# EUROPÄISCHE PATENTSCHRIFT

(11) **EP 2 481 153 B1**
(45) Veröffentlichungstag und Bekanntmachung des Hinweises auf die Patenterteilung: **15.07.2020**
(21) Anmeldenummer: 10747186.4
(22) Anmeldetag: 24.08.2010
(51) Int. Cl.: H03K 17/96, C03C 17/00

(54) **AKTIVE VERGLASUNG MIT INTEGRIERTER ANZEIGEVORRICHTUNG, EIN VERFAHREN ZUR AKTIVIERUNG ODER DEAKTIVIERUNG DER AKTIVEN VERGLASUNG UND DEREN VERWENDUNG**
ACTIVE GLAZING HAVING INTEGRATED DISPLAY DEVICE, A METHOD FOR ACTIVATING OR DEACTIVATING THE ACTIVE GLAZING AND USE THEREOF
VITRAGE ACTIF AVEC DISPOSITIF INTÉGRÉ D'AFFICHAGE, PROCÉDÉ POUR L'ACTIVATION OU LA DÉSACTIVATION DU VITRAGE ACTIF ET POUR SON UTILISATION

(30) Priorität: 25.09.2009 DE 102009044109
(43) Veröffentlichungstag der Anmeldung: 01.08.2012
(73) Patentinhaber: SAINT-GOBAIN GLASS FRANCE, 92400 Courbevoie (FR)
(72) Erfinder: LETOCART, Philippe, B-4730 Raeren (BE); ROYER, Bastien, 53424 Remagen (DE); ORILLARD, Julien, 52062 Aachen (DE); ESSER, Hans-Georg, 52064 Aachen (DE)
(74) Vertreter: Lendvai, Tomas
(86) Internationale Anmeldenummer: PCT/EP2010/062293
(87) Internationale Veröffentlichungsnummer: WO 2011/036009

(56) Entgegenhaltungen:
- EP-A1- 1 544 178
- EP-A1- 1 986 324
- WO-A1-2009/036552
- WO-A2-2008/005505
- DE-A1- 10 308 514
- DE-B3-102005 027 572
- US-A- 5 512 836
- US-A1- 2005 206 623

## Beschreibung

Die vorliegende Erfindung betrifft eine Verglasung mit integrierter Anzeigevorrichtung, ein Verfahren zur Aktivierung oder Deaktivierung der aktiven Verglasung und deren Verwendung.

Es ist bekannt, dass eine Anordnung von zwei Elektroden ein elektrisches Feld durch dielektrisches Material hindurch erzeugt. Nähert sich ein Objekt dem dielektrischen Material wird die Ladungsverteilung und das resultierende elektrische Feld beeinflusst. Durch eine geeignete Auswerteelektronik kann die Änderung des elektrischen Feldes detektiert werden und ein Schaltvorgang und / oder Anzeigevorgang ausgelöst werden.

Beispielsweise offenbart die US 6,452,514 B1 eine Vorrichtung und Methode mit kapazitiven Sensoren oder Feldern von kapazitiven Sensoren zur Auslösung eines Schaltvorgangs.

Aus der EP 1 515 211 A1 ist eine Vorrichtung und ein Verfahren zur kapazitiven Steuerung von Komponenten eines Kraftfahrzeugs bekannt.

Aus der DE 1 129 270 ist eine Anzeigeeinrichtung für den Einschaltzustand von elektrischen Kochplatten hinter dem Betätigungsglied der Schaltstelle bekannt, um eine gegen Stoßeinwirkung stabile und kostengünstige Anzeigevorrichtung über den Einschaltzustand bereitzustellen.

Aus der DD 148 424 ist ein Berührungsschalter mit integrierter Lichtemitteransteuerung bekannt, der einen Trägerstreifen mit Lichtemitterdiode, Ansteuerschaltung und Kontaktflächen enthält.

Aus der DE 103 08 514 A1 ist eine OLED mit Berührungssensor bekannt.

Aus der US 2005/0206623 A1 ist ein Berührungsempfindlicher Elektrolumineszenzschalter bekannt.

Dabei ist es allerdings notwendig, dass die Schaltvorrichtungen und / oder Anzeigevorrichtungen aufwändig an den dielektrischen Materialien angebracht oder aufgebracht und angepasst werden müssen.

Der vorliegenden Erfindung liegt die Aufgabe zugrunde, eine verbesserte aktive Verglasung bereitzustellen, die eine einfache und kostengünstig integrierte Anzeigevorrichtung enthält.

Der Erfindung liegt weiter die Aufgabe zugrunde Verfahren zur Deaktivierung und Aktivierung einer aktiven Verglasung bereitzustellen.

Eine weitere Aufgabe der Erfindung liegt darin, eine neue Verwendung der aktiven Verglasung zu finden.

Die Aufgaben werden durch die in den unabhängigen Patentansprüchen 1, 12 und 15 aufgeführten Merkmale gelöst. Bevorzugte Ausgestaltungen der Erfindung sind durch die Merkmale der abhängigen Ansprüche gegeben.

Die erfindungsgemäße aktive Verglasung mit integrierter Anzeigevorrichtung umfasst auf einer Scheibe eine elektrisch leitfähige Beschichtung, auf der elektrisch leitfähigen Beschichtung eine aktive Schichtstruktur, auf der aktiven Schichtstruktur eine weitere elektrisch leitfähige Schicht, mindestens eine Elektrode gebildet durch Isolationsbereiche in der elektrisch leitfähigen Beschichtung und eine Anzeigefläche gebildet durch mindestens eine Elektrode, wobei die Summe der Anzeigeflächen maximal 1/10 der Fläche der aktiven Verglasung beträgt.

Der Vorteil der erfindungsgemäßen Verglasung besteht darin, dass Anzeigeflächen unabhängig von dem Zustand der aktiven Verglasung geschaltet werden können und dabei vorzeitig über den Zustand der aktiven Verglasung informieren können. Die Anzeigefläche basiert auf der aktiven Schichtstruktur der aktiven Verglasung.

In einer bevorzugten Ausgestaltung der erfindungsgemäßen aktiven Verglasung ist die Summe der Anzeigenflächen maximal 1/20 der Fläche der aktiven Verglasung.

In einer weiteren bevorzugten Ausgestaltung der erfindungsgemäßen aktiven Verglasung weist die Anzeigenfläche maximal 1/100 der Fläche der aktiven Verglasung auf.

Gemäß der Erfindung weisen die Isolationsbereiche eine Breite eine Breite von 5 µm bis 5 mm und bevorzugt von 10 µm bis 2 mm auf. Die Isolationsbereiche können durch Entfernung der Beschichtung oder durch den Isolationsbereich vollständig umlaufende elektrische Trennlinien gebildet werden. Der Isolationsbereich kann elektrisch leitfähig sein und muss von dem Potential der Elektroden und einem Massepotential elektrisch getrennt sein. Mit diesen Isolationsbereichen werden gute Eigenschaften der Anzeigevorrichtung erzielt.

Die elektrisch leitfähige Beschichtung weist erfindungsgemäß bevorzugt eine Schichtdicke von 10 nm bis 1 µm und besonders bevorzugt eine Schichtdicke von 30 nm bis 300 nm auf. Mit diesen Schichtdicken werden besonders gute Ergebnisse erzielt.

In einer weiteren bevorzugten Ausgestaltung der Erfindung enthält die elektrisch leitfähige Beschichtung Leiterbahnen mit einer Breite von 1 µm bis 5 mm und bevorzugt von 10 µm bis 2 mm aufweist.

Die Beschichtungen können über physikalische oder chemische Abscheidung aus der Gasphase aber auch durch Druckverfahren aufgebracht werden. Bevorzugt werden die Beschichtungen mit dem Verfahren des Kathodenzerstäubens aufgebracht.

Gemäß der Erfindung ist es besonders vorteilhaft, wenn die Leiterbahnen der Elektroden eine Breite von 5 µm bis 5 mm und bevorzugt von 10 µm bis 2 mm aufweisen. Mit diesen Elektroden werden gute Eigenschaften zur Ansteuerung des Anzeigebereichs erzielt.

In einer weiteren bevorzugten Ausgestaltung der Erfindung weisen die Elektroden spiralartige, kammartige oder mäanderartige Formen auf.

Die Formen werden durch die bevorzugt linienförmigen Isolationsbereiche über Laserablation oder mechanische Abrasion hergestellt.

Ebenso ist es gemäß der Erfindung vorteilhaft wenn die Elektroden mit Leitungsführungen und Kontaktbereichen mit einem Flachleiter verbunden sind, um auf einfache und für den Benutzer kaum sichtbar die Kontakte aus der aktiven Verglasung heraus zu führen.

Bevorzugt ist auf die weitere elektrisch leitfähige Schicht zusätzlich eine Haftschicht und Deckscheibe aufgebracht und die aktive Verglasung als ein Verbundglas ausgeführt.

In einer weiteren bevorzugten Ausgestaltung der Erfindung enthalten die elektrisch leitfähige Beschichtung leitfähige, bevorzugt transparente und leitfähige Materialien und besonders bevorzugt Silber, Zinkoxid, Indiumzinnoxid, Gallium, Zinnoxid, Gold, Kupfer, Wolfram und / oder Gemische davon. Silber kann als leitfähiger Bestandteil einer Siebdruckpaste aber bevorzugt als mindestens eine transparente Silberschicht mit Schichtdicken von 5 nm bis 30 nm durch Kathodenzerstäuben abgeschieden werden.

In einer bevorzugten Ausgestaltung der Erfindung weist die aktive Schichtstruktur eine schaltbare elektrochrome, lichtstreuende und / oder lichtemittierende, bevorzugt eine elektrochrome Funktion auf. Durch Anlegen einer Spannung an die elektrisch leitfähigen Schichten die Eigenschaften der aktiven Schichtstruktur hinsichtlich Lichttransmission, Lichtstreuung oder Lichtemission diskret oder stufenlos gesteuert werden.

In einer besonders bevorzugten Ausgestaltung der Erfindung ändert die aktive Schichtstruktur im Anzeigebereich schneller ihren Zustand als auf dem übrigen Bereich der aktiven Verglasung. Die Zustandsänderung der aktiven Schichtstrukturen wird auf aktiven Verglasungen durch den spezifischen Schichtwiderstand und der geringen elektrischen Querleitfähigkeit der elektrisch leitfähigen Beschichtungen begrenzt. Die schnellere Zustandsänderung auf den Anzeigenflächen der erfindungsgemäßen Verglasung wird insbesondere aufgrund der kleinen Elektrodenfläche des Anzeigebereichs bewirkt.

Die erfindungsgemäßen aktiven Verglasungen können Flächen von 100 cm² bis 18 m² aufweisen. Bevorzugt weisen die Verglasungen Flächen von 400 cm² bis 4 m² auf, wie sie für Verglasungen von Kraftfahrzeugen und von Bau- und Architekturverglasungen üblich sind.

Besonders bevorzugt ist gemäß der Erfindung ein Signalstromkreis mit Kontaktbereichen der Elektroden verbunden. Ebenso ist ein Leistungsstromkeis mit mindestens der elektrisch leitfähigen Schicht und der weiteren elektrisch leitfähigen Schicht verbunden.

Die Signalstromkreise und Leistungsstromkreise enthalten bevorzugt mindestens einen Schalter und mindestens eine Versorgungs- und Auswerteelektronik die mit den Schaltern, den unterschiedlichen Elektroden und elektrisch leitfähigen Schichten verbunden sind. Ebenso ist es gemäß der Erfindung bevorzugt mindestens einen kapazitiven Sensor und / oder einen induktiver Sensor, einen mechanischen und / oder einen elektromechanischen Schalter in die Verschaltung der aktiven Verglasung zu integrieren. Die Schalter können direkt oder indirekt über die Versorgungs- und Auswerteelektronik die Anzeigefläche und die übrige Fläche der aktiven Verglasung schalten. Der Schalter kann in die aktive Verglasung integriert sein, oder in der Umgebung der Scheibe angebracht sein.

Wenn der Schalter als kapazitiver Schalter in die aktive Verglasung integriert ist, ist es besonders vorteilhaft, dass der Schalter ganz oder teilweise mit Elektroden der Anzeigefläche gebildet wird.

Zur Anzeige von Information ist es gemäß der Erfindung besonders vorteilhaft mindestens zwei Anzeigeflächen zu einem Anzeigefeld zu integrieren.

Die Aufgabe der Erfindung wird weiter durch ein Verfahren zum Aktivieren einer zu aktivierenden Verglasung im inaktiven Zustand gelöst, wobei der Schalter betätigt wird und die Anzeigefläche aktiviert wird und die übrige Verglasung anschließend aktiviert wird.

Die Aufgabe der Erfindung wird durch ein Verfahren zum Deaktivieren einer aktiven Verglasung im aktiven Zustand gelöst, wobei der Schalter betätigt wird und die Anzeigefläche deaktiviert wird und die übrige Verglasung anschließend deaktiviert wird.

In einer Ausgestaltung der erfindungsgemäßen Verfahren werden Zwischenzustände der aktiven Verglasung über Felder von Anzeigeflächen sequenzweise angezeigt.

In einer vorteilhaften Ausgestaltung der Erfindung hat die elektrisch leitfähige Beschichtung eine Schichtdicke von 10 nm bis 1 µm aufweist, bevorzugt von 30 nm bis 300 nm.

In einer vorteilhaften Ausgestaltung der Erfindung weist die elektrisch leitfähige Beschichtung Leiterbahnen mit einer Breite von 1 µm bis 5 mm und bevorzugt von 10 µm bis 2 mm auf.

In einer vorteilhaften Ausgestaltung der Erfindung enthält die elektrisch leitfähige Beschichtung Silber, Zinkoxid, Indiumzinnoxid, Gallium, Zinnoxid, Gold, Kupfer, Wolfram und / oder Gemische davon.

In einer vorteilhaften Ausgestaltung der Erfindung sind die Elektroden mit Leitungsführungen und Kontaktbereichen mit einem Flachleiter verbunden.

In einer vorteilhaften Ausgestaltung der Erfindung enthält die aktive Verglasung mindestens einen Signalstromkreis, wobei der Signalstromkreis mindestens mit Kontaktbereichen der Elektroden verbunden ist.

In einer vorteilhaften Ausgestaltung der Erfindung enthält die aktive Verglasung mindestens einem Leistungsstromkeis, wobei der Leistungsstromkreis mit mindestens der elektrisch leitfähigen Schicht und der weiteren elektrisch leitfähige Schicht verbunden ist.

In einer vorteilhaften Ausgestaltung der Erfindung bilden mindestens zwei Anzeigeflächen ein Anzeigefeld.

Erfindungsgemäß wurde eine neue Verwendung der aktiven Verglasung als Fahrzeug-, Bau- oder Innenarchitekturverglasung mit integrierter Schalt - und / oder Anzeigefläche gefunden.

Ausführungsbeispiele der Erfindung sind in den Figuren 1 bis 11 schematisiert dargestellt.

Es zeigen:
- Fig. 1: eine Draufsicht auf ein Ausführungsbeispiel einer erfindungsgemäßen Verglasung (I),
- Fig. 2: einen Querschnitt durch ein Ausführungsbeispiel einer erfindungsgemäßen Verglasung (I) gemäß dem Schnitt A-A' der Fig. 1,
- Fig. 3: einen Längsschnitt durch ein Ausführungsbeispiel einer erfindungsgemäßen Verglasung (I) gemäß dem Schnitt B'-B der Fig. 1,
- Fig. 4: einen Querschnitt mit schematisierter Verschaltung einer erfindungsgemäßen aktiven Verglasung (I) gemäß dem Schnitt A-A' der Fig. 1,
- Fig. 5: einen Querschnitt einer erfindungsgemäßen aktiven Verglasung (I) gemäß dem Schnitt A-A' der Fig. 1,
- Fig. 6: eine Draufsicht auf ein Ausführungsbeispiel einer erfindungsgemäßen Verglasung (I) mit schematisierter Verschaltung,
- Fig. 7: eine Draufsicht auf ein weiteres Ausführungsbeispiel einer erfindungsgemäßen Verglasung (I) mit schematisierter Verschaltung,
- Fig. 8: eine Schema einer Draufsicht auf ein weiteres Ausführungsbeispiel einer erfindungsgemäßen Verglasung (I) mit schematisierter Verschaltung der Verglasung,
- Fig. 9: ein Flussdiagramm eines erfindungsgemäßen Verfahrens zur Anzeige eines Zustands einer aktiven Verglasung (I) und eine Draufsicht auf Ausführungsbeispiele der Zustandsanzeige,
- Fig. 10: eine Draufsicht auf eine erfindungsgemäße Ausgestaltung eines Anzeigefeldes einer aktiven Verglasung (I) und
- Fig. 11: ein Flussdiagramm eines erfindungsgemäßen Verfahrens zur Herstellung einer erfindungsgemäßen Verglasung (I).

Es folgt die Erläuterung der Erfindung anhand der Figuren nach Aufbau und gegebenenfalls auch nach Wirkweise der dargestellten Erfindung.

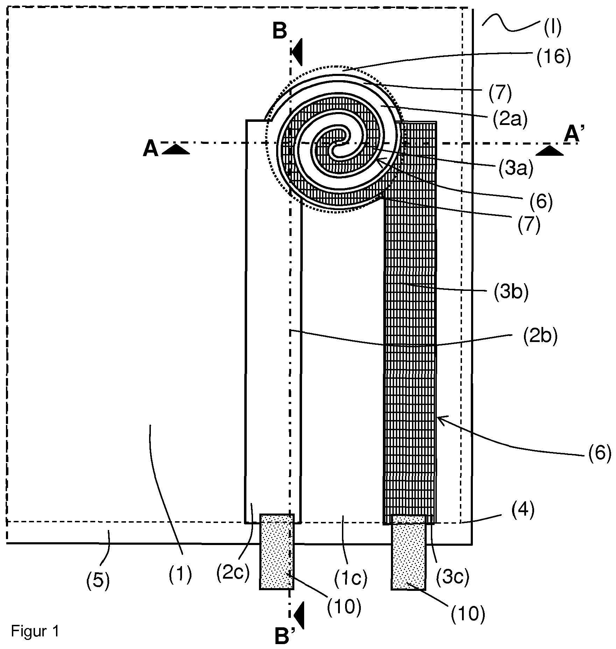

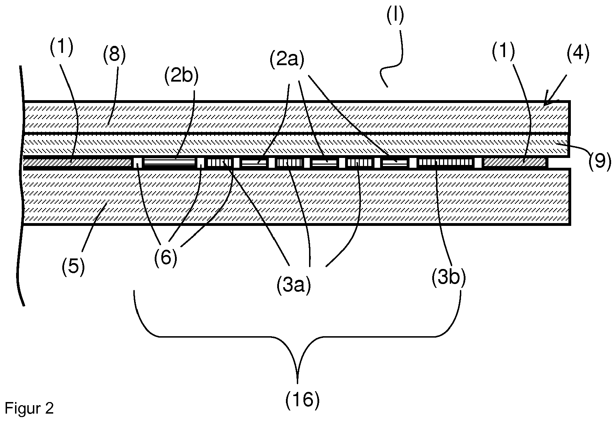

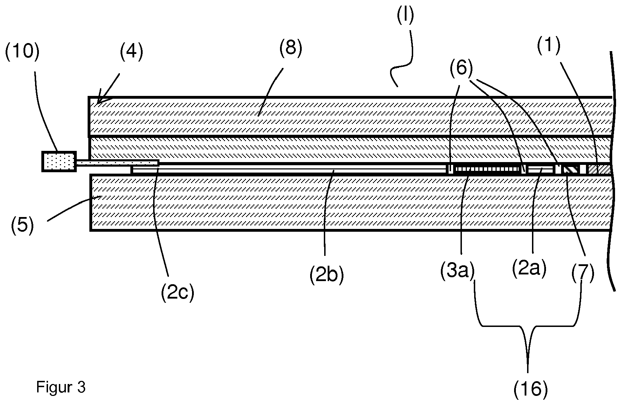

Figuren 1 bis 3 zeigen eine Draufsicht auf einen Querschnitt und einen Längsschnitt durch ein Ausführungsbeispiel einer erfindungsgemäßen Verglasung (I). Auf eine Windschutzscheibe (5) eines Fahrzeugs war eine elektrisch leitfähige transparente wärmereflektierende Beschichtung (1) mit einer transparenten leitfähigen Silberschicht aufgebracht worden. Die Verglasung (I) hatte einen g-Wert von 70 %. Die Gesamtschichtdicke der Beschichtung (1) betrug 200 nm. Die Fläche der Verglasung (I) mit der elektrisch leitfähigen Beschichtung (1) betrug 5000 cm². In der elektrisch leitfähigen Beschichtung (1) waren spiralförmige Isolationsbereiche (6) mit einer Breite von 0,1 mm vorhanden. Die Isolationsbereiche (6) trennten zwei ineinander liegende spiralförmige Elektroden (2a)(3a) elektrisch voneinander. Die Leiterbahnen der Elektroden (2a)(3a) hatten eine Breite von 1 mm. Durch weitere Isolationsbereiche (6) wurden Leitungsführungen (2b)(3b) und Kontaktbereiche (2c)(3c) von der elektrisch leitfähigen Schichtstruktur (1) elektrisch getrennt. Im Randbereich (4) der Glasscheibe (1) waren die Kontaktbereiche (2c)(3c) mit Flachleitern (10) verbunden. Die Elektroden (2a)(3a), Leitungsführungen (2b)(3b) und Kontaktbereiche (2c)(3c) waren transparent und für den Betrachter nicht oder kaum sichtbar. Die Elektroden (2a)(3a) wurden mit einer Wechselspannung von 2 MHz angeregt und ein elektrisches Wechselfeld wurde erzeugt. In Abhängigkeit von der Breite der Isolationsbereiche (6), der Form der Elektroden (2a)(3a), der Schichtdicke der Elektroden (2a)(3a), der Glasscheibe (5) und der verwendeten Materialien wurde eine Impedanz zwischen den Elektroden gemessen. Näherte sich ein Körper, beispielsweise ein menschlicher Finger, den Elektroden (2a)(3a) und / oder der Glasscheibe (5), änderte sich das elektrische Feld und in der Folge die Impedanz zwischen den Elektroden (2a)(3a). Die Änderung der Impedanz wurde messtechnisch erfasst. Das elektrische Wechselfeld durchdrang die Glasscheibe (5). Auf der der elektrisch leitfähigen Schichtstruktur abgewandten Seite der Glasscheibe (5) wurde im Bereich der Elektroden (2a)(3a) durch das Wechselfeld eine Schaltfläche (16) mit einer Fläche von 9 cm² erzeugt. Zur Vermeidung von ungewollten Detektionen von Körpern außerhalb der Schaltfläche (16) war die elektrisch leitfähige Beschichtung (1) außerhalb des Elektrodenbereichs (2a)(3a) über einen weiteren Kontaktbereich (3c) auf Massepotential gelegt. Zur Erhöhung der Sensitivität der Anordnung wurden über weitere Isolationsbereiche (6) Zwischenbereiche (7) zwischen der elektrisch leitfähigen Beschichtung (1) und den Elektroden (2a)(2b) von der elektrisch leitfähigen Beschichtung (1) elektrisch isoliert. Die Scheibe (5) mit der elektrisch leitfähigen Beschichtung (1), den Isolationsbereichen (6) und Teilen des Flachleiters (10) waren über eine Haftschicht (9) mit Polyvinylbutyral und lumineszierenden Partikeln mit einer Deckscheibe (8) verbunden. Die Deckscheibe (8) war im Fahrzeug außenliegend. Die Schaltfläche (16) war zum Fahrgastraum hin ausgerichtet. Die Schaltfläche (16) konnte vom Innenraum des Fahrzeugs aus bedient werden. Die Schaltfläche (16) wurde über Lumineszenz im Polyvinylbutyral über eine dynamische Projektion (Head-up Display, nicht dargestellt) im Fahrzeug dynamisch markiert.

Es war für den Fachmann nicht vorhersehbar, dass auf einfache Weise eine transparente Schaltfläche (16) aus Bereichen einer wärmereflektierenden und beheizbaren Schicht (1) einer Windschutzscheibe gebildet werden konnte, die zur Ansteuerung von Funktionen des Fahrzeugs genutzt werden kann.

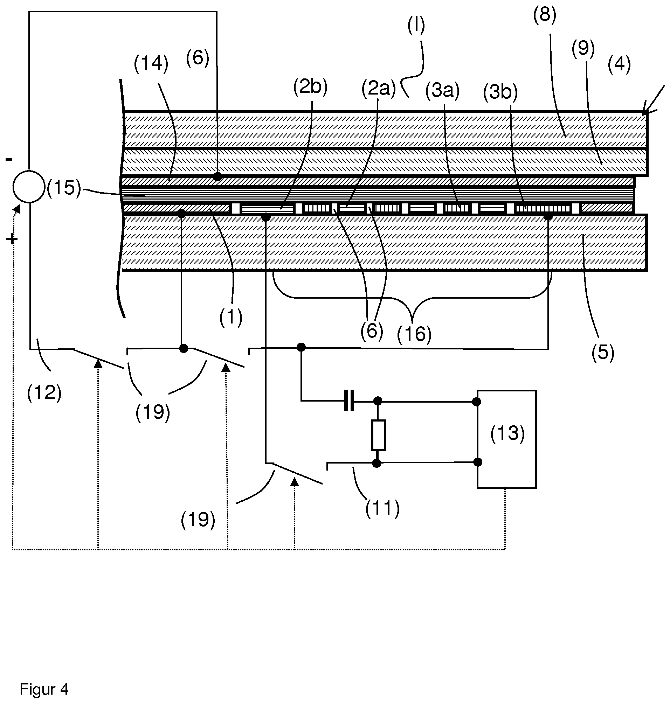

Figur 4 zeigt einen alternativen Querschnitt mit schematisierter Verschaltung einer erfindungsgemäßen aktiven Verglasung (I) gemäß dem Schnitt A-A' der Fig. 1. Die Verglasung (I) enthielt zwischen den Elektrodenstrukturen (2a)(3a) und einer zusätzlichen weiteren elektrisch leitfähigen Schicht (14) eine elektrochrome Schichtstruktur (15). Bei Anlegen einer elektrischen Gleichspannung über einen Signalstromkreis zwischen den Elektrodenstrukturen (2a)(3a) und der weiteren elektrisch leitfähigen Schicht (14) konnte der Lichttransmissionsgrad der elektrochromen Schichtstruktur (15) im Anzeigebereich (16) auf einer Fläche von 9 cm² eingestellt werden. Zur Ansteuerung des Anzeigebereichs (16) enthielt der Signalstromkreis einen Schalter (19) der mit der Versorgungs- und Auswerteelektronik (13) verbunden war. Durch Anlegen einer elektrischen Gleichspannung über einen Leistungsstromkreis zwischen der elektrisch leitfähigen Schichtstruktur (1) und der weiteren elektrisch leitfähige Beschichtung (14) konnte auch der Transmissionsgrad der aktiven Verglasung (I) auf einer Fläche von etwa 4990 cm² eingestellt werden. Der Leistungsstromkreis (12) enthielt ebenfalls mindestens einen Schalter (19), der ebenfalls mit der Versorgungs- und Auswerteelektronik (13) verbunden war. Durch die unabhängige Schaltmöglichkeit von Anzeigebereich (16) und dem übrigen Bereich der aktiven Verglasung (I) konnte zuerst die schnell reagierende Anzeigefläche (16) geschaltet werden und danach die übrige Fläche der aktiven Verglasung (I). Die Elektroden (2a)(3a) wurden weiter zur Ausbildung des elektrischen Wechselfeldes einer Schaltfläche (16) genutzt, sodass eine kombinierte Schalt- und Anzeigefläche (16) vorhanden war. Zusätzlich wurden die Elektroden (2a)(3a) mit einer Wechselspannung von 2 MHz angeregt, um ein elektrisches Wechselfeld für die Schaltfläche (16) bereitzustellen. Zur Messung der Impedanz zwischen den Elektrodenstrukturen (2a)(2b) wurden die Kontaktbereiche (2c)(3c) über einen Signalstromkreis (11) mit der Versorgungs- und Auswerteelektronik (13) verbunden. Ein Hochpass im Signalstromkreis (11) trennte die Wechselspannungen und die Gleichspannungen. In einer vorteilhaften Ausgestaltung der Erfindung kann der Schalter (19) als kapazitiver Schalter ausgestaltet sein, der ganz oder teilweise mit Elektroden (2a)(3a) der Anzeigeflächen (16) gebildet wird.

Bei Detektion eines Körpers im elektrischen Wechselfeld des Schaltbereichs (16) wurde beispielsweise ein Schalter (19) für den Anzeigebereich geschlossen und die aktive Schichtstruktur (15) änderte zuerst im Anzeigebereich (16) ihren Zustand. Durch die geringe Fläche von 9 cm² änderte die Schichtstruktur (15) im Anzeigebereich (16) innerhalb von 10 ms bis 10 s den Transmissionsgrad. Der Bediener wurde damit innerhalb kurzer Zeit über die Detektion informiert. Die Änderung des Schaltzustandes der aktiven Verglasung mit einer Fläche von 4990 cm² erfolgte danach innerhalb einer Zeitspanne von 20 s bis 3600 s.

Es war für den Fachmann nicht vorhersehbar, dass auf einfache Weise eine Schalt- / und schnell reagierende Anzeigefläche (16) in bestehende elektrisch leitfähige Beschichtungen (1) integriert werden konnte und damit eine elektrochrome Verglasung (I) bereitgestellt werden konnte, die einem Bediener innerhalb kurzer Zeit den Schaltzustand der elektrochromen Verglasung (I) anzeigte.

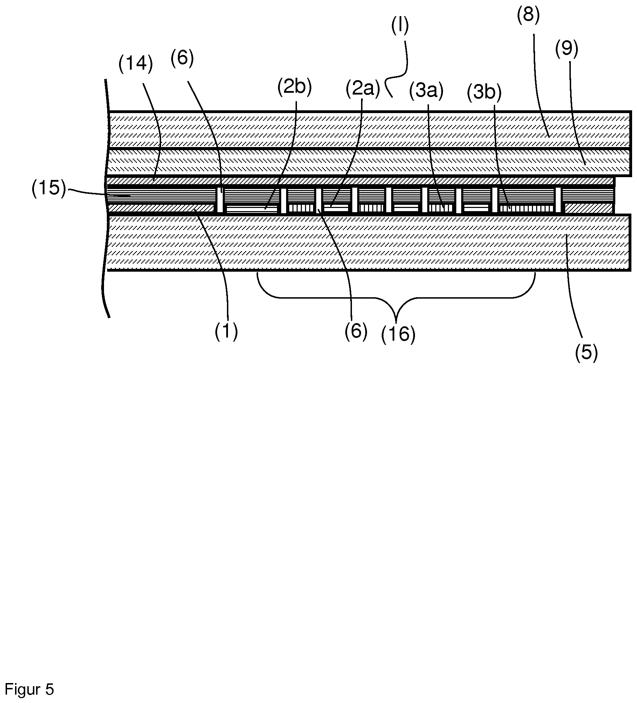

Fig. 5 zeigt eine weitere Ausgestaltung der erfindungsgemäßen aktiven Verglasung gemäß dem Ausführungsbeispiel der Fig. 4. Der Unterschied zu der Verglasung nach Fig. 4 liegt darin, dass Isolationsbereiche (6) zusätzlich in der aktiven Schichtstruktur (15) eingebracht waren. Durch diese erfindungsgemäße Ausgestaltung konnte die Empfindlichkeit des Schaltbereichs (16) und / oder die Reaktionszeit des Anzeigebereichs (16) weiter erhöht werden.

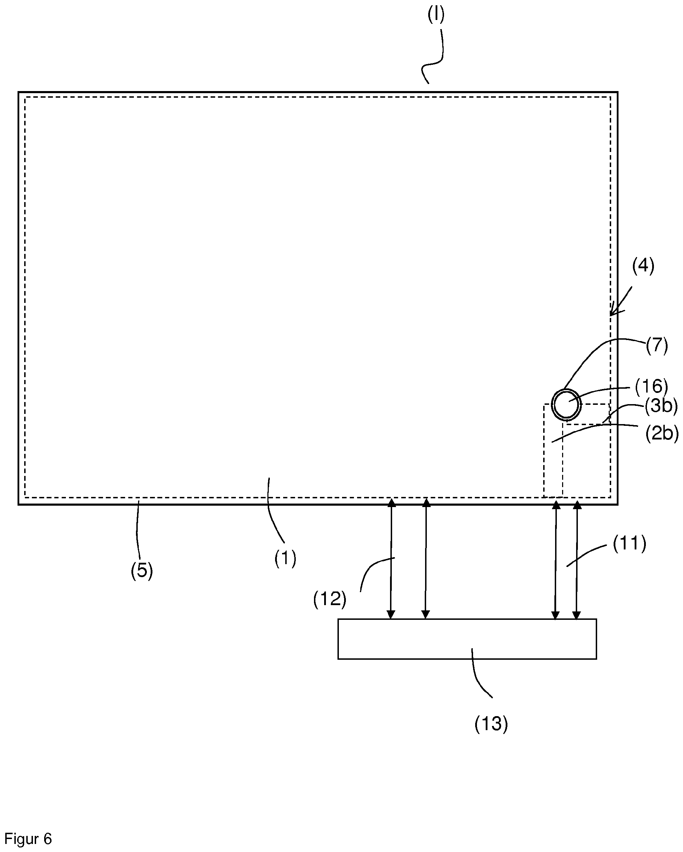

Fig. 6 zeigt Ausgestaltungen der erfindungsgemäßen Wärmeschutzverglasung (I) mit einer Schaltfläche (16) oder eine Ausgestaltung als aktive elektrochrome Verglasung mit Schalt- / und Anzeigefläche (16). Die elektrisch leitfähige Schichtstruktur (1) war im Randbereich (4) der Scheibe (5) rahmenförmig randentschichtet und lag auf Massepotential. Die aktive Verglasung (I) war über schaltbare Leistungsstromkreise (12) und schaltbare Signalstromkreise (11) mit der Versorgungs- und Auswerteelektronik (13) verbunden.

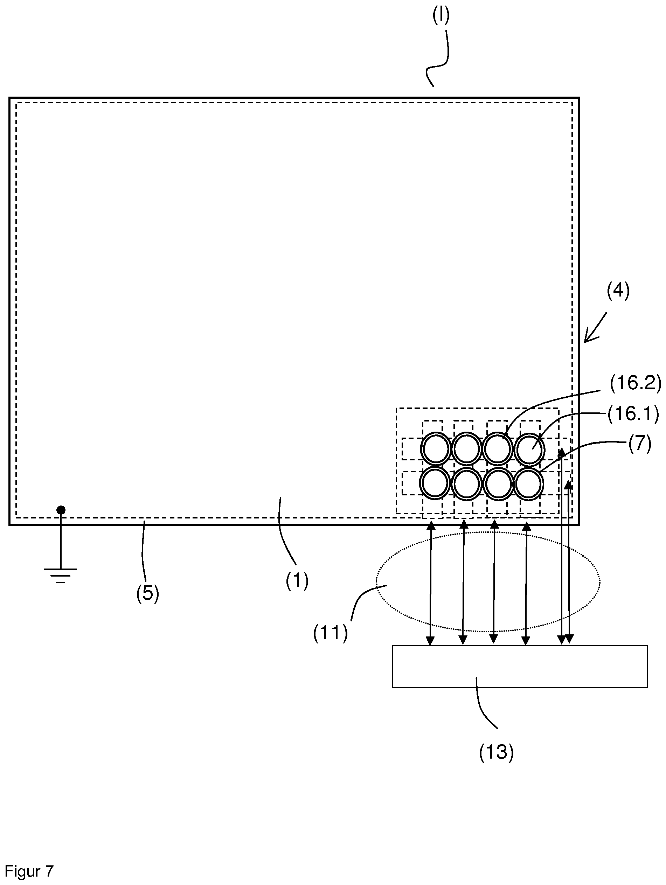

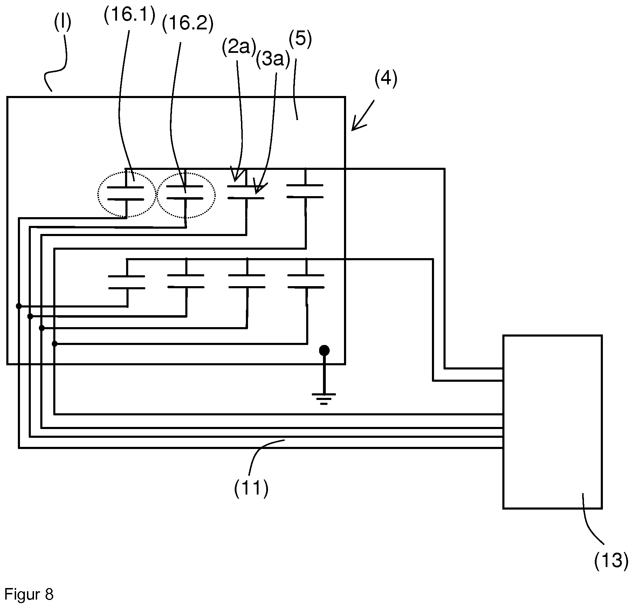

Fig. 7 und Fig. 8 zeigen in Fortführung des Ausführungsbeispiels gemäß der Fig. 6 eine erfindungsgemäße Wärmeschutzverglasung mit einem Feld von Schaltflächen (16.1)(16.2) oder in einer alternativen Ausgestaltung eine aktive elektrochrome Verglasung mit einem Feld von Schalt- und / oder Anzeigeflächen (16.1)(16.2). Die Elektroden (2a)(3a), die Leitungsführungen (2b)(3b) der Elektroden (2a)(3a) waren so angeordnet, dass eine Überlappung außerhalb des Anzeigebereichs (16) vermieden wurde. Insbesondere wurde dadurch eine Ansteuerung der aktiven Schichtstruktur (15) im Bereich der Leitungszuführungen (2b)(3b) vermieden.

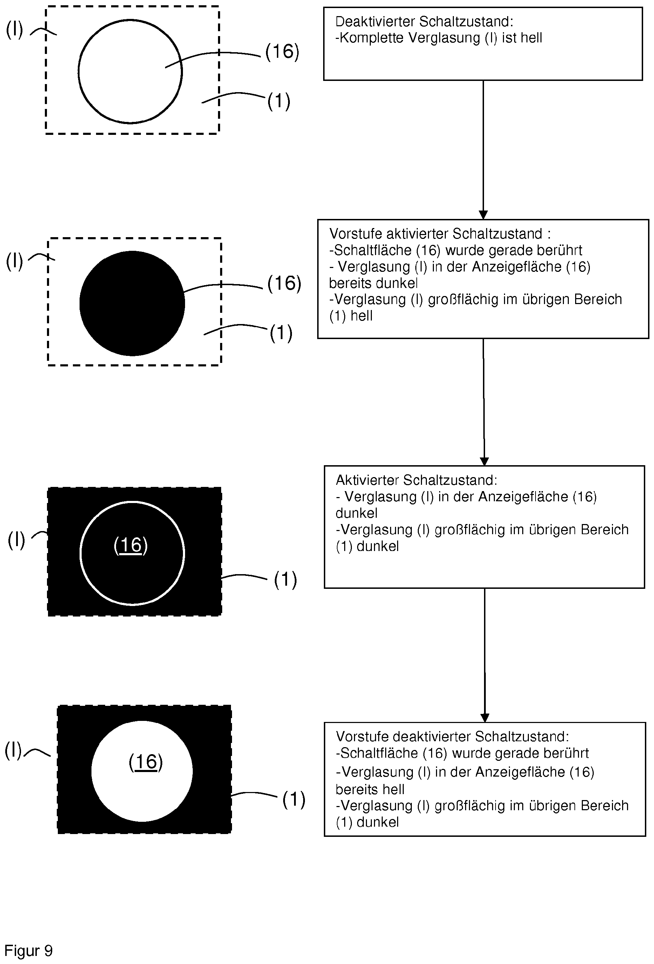

Fig. 9 zeigt detailliert ein Ausführungsbeispiel eines erfindungsgemäßen Verfahrens zum Aktivieren oder Deaktivieren einer elektrochromen Verglasung (I) sowie den Zustandswechsel von opak zu transparent innerhalb der Anzeigefläche (16) und auf der übrigen aktiven Verglasung (I) mit der elektrisch leitfähigen Beschichtung (1).

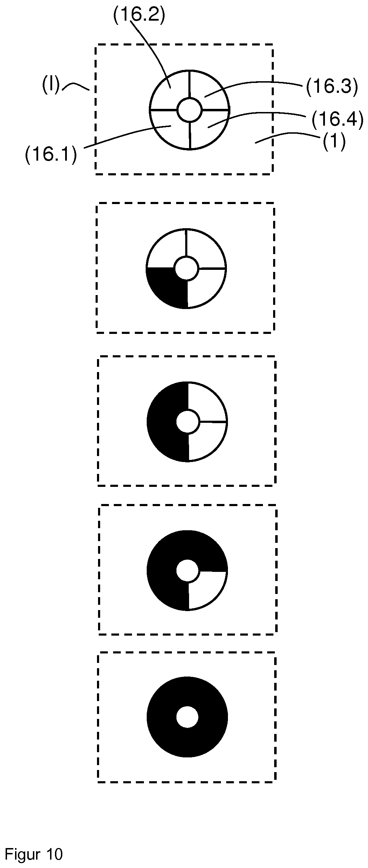

Fig. 10 zeigt ein Feld von Anzeigeflächen (16.1) (16.2) (16.3) (16.4) zur Anzeige von Zwischenzuständen im Transmissionsgrad einer elektrochromen Verglasung (I) zur Information eines Bedieners. Im Ausführungsbeispiel konnte die aktive Verglasung (I) über drei Zwischenzustände von vollständig transparent bis zu opak geschaltet werden und der gewählte Zustand angezeigt werden. Durch mehrfaches Detektieren eines Körpers an mindestens einer Schaltfläche (16.1) 16.1) (16.2) (16.3) (16.4) wurden segmentweise der Schaltzustand der aktiven Verglasung (I) und die Anzeigefläche (16.1) 16.1) (16.2) (16.3) (16.4) in Segmenten aktiviert. Der Bediener wurde somit unmittelbar und eindeutig über den gewählten Schaltzustand der elektrochromen Verglasung (I) informiert, bevor die elektrochrome Verglasung den gewählten Zustand einnahm.

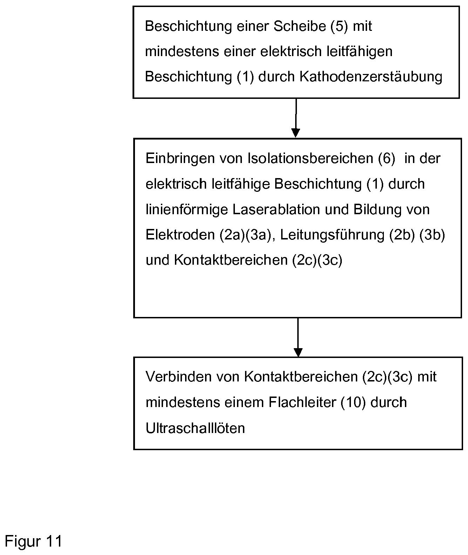

Fig. 11 zeigt in einem Flussdiagramm die detaillierten Verfahrensschritte zur Herstellung einer erfindungsgemäßen Verglasung mit Schaltvorrichtung.

Es war für den Fachmann nicht vorhersehbar, dass sich auf einfache Weise vorhandene elektrisch leitfähige Schichtstrukturen (1) oder Elektrodenschichten (1)(14) zu einer Schaltfläche und / oder Anzeigefläche (16) für Schaltzustände einer aktiven Verglasungen (I) weiterentwickeln ließen, ohne die vorhandene Funktion der Verglasung / aktiven Verglasung (I) zu beeinträchtigen.

### Bezugszeichenliste:

- (I): Verglasung / Aktive Verglasung
- (1): elektrisch leitfähige Beschichtung
- (2a): erste Elektrode
- (2b): Leitungsführung erste Elektrode
- (2c): Kontaktbereich erste Elektrode
- (3a): zweite Elektrode
- (3b): Leitungsführung zweite Elektrode
- (3c): Kontaktbereich zweite Elektrode
- (4): Randbereich
- (5): Scheibe
- (6): Isolationsbereich
- (7): Zwischenbereiche
- (8): Deckscheibe
- (9): Haftschicht
- (10): Flachleiter
- (11): Signalstromkreis
- (12): Leistungsstromkreis
- (13): Versorgungs- und Auswerteelektronik
- (14): weitere elektrisch leitfähige Schicht
- (15): Aktive Schichtstruktur
- (16): Schaltfläche / Anzeigefläche
- (16.1)(16.2)(16.3)(16.4): Segmente Schaltfläche / Anzeigefläche
- (19): Schalter

## Patentansprüche

1. Aktive Verglasung (I) mit integrierter Anzeigevorrichtung, umfassend
- auf einer Scheibe (5) eine elektrisch leitfähige Beschichtung (1),
- auf der elektrisch leitfähigen Beschichtung (1) eine aktive Schichtstruktur (15),
- auf der aktiven Schichtstruktur (15) eine weitere elektrisch leitfähige Schicht (14),
- mindestens eine Elektrode (2a)(3a) gebildet durch Isolationsbereiche (6) in der elektrisch leitfähigen Beschichtung (1) und
- eine Anzeigefläche (16) gebildet durch eine der mindestens einen Elektrode (2a)(3a) basierend auf der aktiven Schichtstruktur,
wobei eine Summe der Anzeigeflächen (16) maximal 1/10 der Fläche der aktiven Verglasung (I) beträgt und die Anzeigeflächen (16) unabhängig von dem Zustand der übrigen aktiven Verglasung (I) geschaltet werden können, **dadurch gekennzeichnet, dass** die Isolationsbereiche (6) eine Breite von 5 µm bis 5 mm aufweisen.

2. Aktive Verglasung (I) mit integrierter Anzeigevorrichtung nach Anspruch 1, wobei die Summe der Anzeigenflächen (16) maximal 1/20 der Fläche der aktiven Verglasung (I) und bevorzugt maximal 1/100 der Fläche der aktiven Verglasung (I) beträgt.

3. Aktive Verglasung (I) mit integrierter Anzeigevorrichtung nach einem der Ansprüche 1 bis 2, wobei die Isolationsbereiche (6) eine Breite von 10 µm bis 2 mm aufweisen

4. Aktive Verglasung (I) mit integrierter Anzeigevorrichtung nach einem der Ansprüche 1 bis 3, wobei die Isolationsbereiche (6) zusätzlich in der aktiven Schichtstruktur und / oder der weiteren elektrisch leitfähigen Schicht (14) eingebracht sind.

5. Aktive Verglasung (I) mit integrierter Schaltvorrichtung nach einem der Ansprüche 1 bis 4, wobei die Elektroden (2a)(3a) eine Breite von 5 µm bis 5 mm und bevorzugt von 10 µm bis 2 mm aufweisen.

6. Aktive Verglasung (I) mit integrierter Anzeigevorrichtung nach einem der Ansprüche 1 bis 5, wobei mindestens eine der Elektroden (2a)(3a) eine spiralartige, kammartige oder mäanderartige Form aufweist.

7. Aktive Verglasung (I) mit integrierter Anzeigevorrichtung nach einem der Ansprüche 1 bis 6, wobei auf die weitere elektrisch leitfähige Schicht (14) zusätzlich eine Haftschicht (9) und Deckscheibe (8) aufgebracht sind.

8. Aktive Verglasung (I) mit integrierter Anzeigevorrichtung nach einem der Ansprüche 1 bis 7, wobei die aktive Schichtstruktur (15) eine schaltbare elektrochrome, lichtstreuende und / oder lichtemittierende, bevorzugt eine elektrochrome Funktion aufweist.

9. Aktive Verglasung (I) mit integrierter Anzeigevorrichtung nach einem der Ansprüche 1 bis 8, wobei die aktive Schichtstruktur (15) im Anzeigebereich aufgrund der kleinen Elektrodenfläche des Anzeigebereichs schneller den Zustand ändert als auf dem übrigen Bereich der aktiven Verglasung (I).

10. Aktive Verglasung (I) mit integrierter Anzeigevorrichtung nach einem der Ansprüche 1 bis 9 mit mindestens einem Schalter (19) und mit mindestens einer Versorgungs- und Ansteuerelektronik (13), wobei der Schalter (19) mit der Versorgungs- und Ansteuerelektronik (13) verbunden ist und der Schalter (19) mindestens einen kapazitiven Berührungssensor und / oder einen induktiven Berührungssensor, einen mechanischen und / oder einen elektromechanischen Schalter enthält.

11. Aktive Verglasung (I) mit integrierter Anzeigevorrichtung nach Anspruch 10, wobei der Schalter einen kapazitiven Schalter enthält, der ganz oder teilweise mit Elektroden (2a)(3a) der Anzeigeflächen (16) gebildet wird.

12. Verfahren zum Aktivieren einer aktiven Verglasung im inaktiven Zustand nach einem der Ansprüche 10 bis 11, wobei
a. der Schalter (19) betätigt wird und die Anzeigefläche (16) aktiviert wird und
b. die übrige Verglasung (I) anschließend aktiviert wird.

13. Verfahren zum Deaktivieren einer aktiven Verglasung im aktiven Zustand nach einem der Ansprüche 10 bis 11, wobei
a. der Schalter (19) betätigt wird und die Anzeigefläche (16) deaktiviert wird und
b. die übrige Verglasung (I) anschließend deaktiviert wird.

14. Verfahren nach Anspruch 12 oder 13, wobei Zwischenzustände im Transmissionsgrad der aktiven Verglasung (I) über Felder von Anzeigeflächen angezeigt werden.

15. Verwendung der aktiven Verglasung (I) nach einem der Ansprüche 1 bis 11 als Fahrzeug-, Bau- oder Innenarchitekturverglasung mit integrierter Schalt- und Anzeigevorrichtung.

## Claims

1. Active glazing (I) having an integrated display device, comprising
- an electrically conductive coating (1) on a pane (5),
- an active layer structure (15) on the electrically conductive coating (1),
- another electrically conductive layer (14) on the active layer structure (15),
- at least one electrode (2a) (3a) formed by insulation regions (6) in the electrically conductive coating (1), and
- a display surface (16) formed by one of the at least one electrode (2a) (3a) based on the active layer structure,
wherein a sum of the display surfaces (16) is at most 1/10 of the area of the active glazing (I) and the display surfaces (16) can be switched regardless of the state of the remainder of the active glazing (I)
**characterized in that** the insulation regions (6) have a width of 5 µm to 5 mm.

2. Active glazing (I) having an integrated display device according to claim 1, wherein the sum of the display surfaces (16) is at most 1/20 of the area of the active glazing (I) and preferably at most 1/100 of the area of the active glazing (I).

3. Active glazing (I) having an integrated display device according to one of claims 1 through 2, wherein the insulation regions (6) have a width of 10 µm to 2 mm.

4. Active glazing (I) having an integrated display device according to one of claims 1 through 3, wherein the insulation regions (6) are additionally incorporated into the active layer structure and/or the other electrically conductive layer (14).

5. Active glazing (I) having an integrated display device according to one of claims 1 through 4, wherein the electrodes (2a) (3a) have a width of 5 µm to 5 mm and preferably of 10 µm to 2 mm.

6. Active glazing (I) having an integrated display device according to one of claims 1 through 5, wherein at least one of the electrodes (2a) (3a) has a spiral-like, comb-like, or meandering shape.

7. Active glazing (I) having an integrated display device according to one of claims 1 through 6, wherein an adhesive layer (9) and cover plate (8) are additionally applied to the other electrically conductive layer (14).

8. Active glazing (I) having an integrated display device according to one of claims 1 through 7, wherein the active layer structure (15) has a switchable electrochromic, light-scattering, and / or light-emitting, preferably an electrochromic function.

9. Active glazing (I) having an integrated display device according to one of claims 1 through 8, wherein due to the small electrode surface of the display region, the active layer structure (15) changes state faster in the display surface (16) than on the remaining area of the active glazing (I).

10. Active glazing (I) having an integrated display device according to one of claims 1 through 9, with at least one switch (19) and with at least one supply and control electronics unit (13), wherein the switch (19) is connected to the supply and control electronics unit (13) and the switch (19) includes at least one capacitive touch sensor and / or an inductive touch sensor, a mechanical and / or an electromechanical switch.

11. Active glazing (I) having an integrated display device according to claim 10, wherein the switch includes a capacitive switch that is completely or partially formed with the electrodes (2a) (3a) of the display surfaces (16).

12. Method for activating an active glazing in the inactive state according to one of claims 10 through 11, wherein
a. the switch (19) is actuated and the display surface (16) is activated, and
b. the remainder of the glazing (I) is subsequently activated.

13. Method for deactivating an active glazing in the active state according to one of claims 10 through 11, wherein
a. the switch (19) is actuated and the display surface (16) is deactivated, and
b. the remainder of the glazing (I) is subsequently deactivated.

14. Method according to claim 12 or 13, wherein intermediate states in the transmittance level of the active glazing (I) are indicated via fields of display surfaces.

15. Use of the active glazing (I) according to one of claims 1 through 11 as a vehicle, building, or interior architectural glazing having an integrated switching and display device.

## Revendications

1. Vitrage actif (I) avec dispositif d'affichage intégré, comportant
- un revêtement (1) conducteur de l'électricité sur une plaque (5) ;
- une structure stratifiée active (15) sur le revêtement (1) conducteur de l'électricité ;
- une autre couche (14) conductrice de l'électricité sur la structure stratifiée active (15) ;
- au moins une électrode (2a) (3a) formée par des zones d'isolation (6) dans le revêtement (1) conducteur de l'électricité ; et
- une surface d'affichage (16) formée par l'une de ladite au moins une électrode (2a) (3a) sur la base de la structure stratifiée active,
dans lequel une somme des surfaces d'affichage (16) représente au maximum 1/10 de la surface du vitrage actif (I) et les surfaces d'affichage (16) peuvent être mises en circuit indépendamment de l'état du vitrage actif (I) restant,
**caractérisé par le fait que** les zones d'isolation (6) présentent une largeur de 5 µm à 5 mm.

2. Vitrage actif (I) avec dispositif d'affichage intégré, selon la revendication 1, dans lequel la somme des surfaces d'affichage (16) représente au maximum 1/20 de la surface du vitrage actif (I) et, de préférence, au maximum 1/100 de la surface du vitrage actif (I).

3. Vitrage actif (I) avec dispositif d'affichage intégré, selon l'une des revendications 1 et 2, dans lequel les zones d'isolation (6) présentent une largeur de 10 µm à 2 mm.

4. Vitrage actif (I) avec dispositif d'affichage intégré, selon l'une des revendications 1 à 3, dans lequel les zones d'isolation (6) sont en outre introduites dans la structure stratifiée active et/ou l'autre couche (14) conductrice de l'électricité.

5. Vitrage actif (I) avec dispositif d'affichage intégré, selon l'une des revendications 1 à 4, dans lequel les électrodes (2a) (3a) présentent une largeur de 5 µm à 5 mm et, de préférence, de 10 µm à 2 mm.

6. Vitrage actif (I) avec dispositif d'affichage intégré, selon l'une des revendications 1 à 5, dans lequel au moins l'une des électrodes (2a)(3a) présente une forme en spirale, en peigne ou en méandres.

7. Vitrage actif (I) avec dispositif d'affichage intégré, selon l'une des revendications 1 à 6, dans lequel en outre une couche adhésive (9) et une plaque de recouvrement (8) sont appliquées sur l'autre couche (14) conductrice de l'électricité.

8. Vitrage actif (I) avec dispositif d'affichage intégré, selon l'une des revendications 1 à 7, dans lequel la structure stratifiée active (15) présente une fonction électrochromique, de diffusion de lumière et/ou d'émission de lumière, de préférence électrochromique, commutable.

9. Vitrage actif (I) avec dispositif d'affichage intégré, selon l'une des revendications 1 à 8, dans lequel la structure stratifiée active (15) dans la zone d'affichage (16) change d'état sur la base de la petite surface d'électrode de la zone d'affichage plus rapidement que sur la zone restante du vitrage actif (I).

10. Vitrage actif (I) avec dispositif d'affichage intégré, selon l'une des revendications 1 à 9, comportant au moins un commutateur (19) et comportant au moins une électronique d'alimentation et de commande (13), dans lequel le commutateur (19) est connecté à l'électronique d'alimentation et de commande (13) et le commutateur (19) contient au moins un capteur tactile capacitif et/ou un capteur tactile inductif, un commutateur mécanique et/ou un commutateur électromécanique.

11. Vitrage actif (I) avec dispositif d'affichage intégré, selon la revendication 10, dans lequel le commutateur contient un commutateur capacitif, qui est entièrement ou partiellement formé avec des électrodes (2a)(3a) des surfaces d'affichage (16).

12. Procédé d'activation d'un vitrage actif dans l'état inactif selon l'une des revendications 10 à 11, dans lequel
a. le commutateur (19) est actionné et la surface d'affichage (16) est activée ; et
b. le vitrage restant (I) est ensuite activé.

13. Procédé de désactivation d'un vitrage actif dans l'état actif selon l'une des revendications 10 et 11, dans lequel
a. le commutateur (19) est actionné et la surface d'affichage (16) est désactivée ; et
b. le vitrage restant (I) est ensuite désactivé.

14. Procédé selon l'une des revendications 12 ou 13, dans lequel des états intermédiaires dans le facteur de transmission du vitrage actif (I) sont affichés sur des champs de surfaces d'affichage.

15. Utilisation du vitrage actif (I) selon l'une des revendications 1 à 11 en tant que vitrage de véhicule, de bâtiment ou d'architecture intérieure avec dispositif de commutation et d'affichage intégré.
